# FASCICULE DE BREVET EUROPEEN

(11) **EP 0 287 451 B1**
(45) Date de publication et mention de la délivrance du brevet: **15.09.1993**
(21) Numéro de dépôt: 88400875.6
(22) Date de dépôt: 12.04.1988
(51) Int. Cl.: H01L 21/66

(54) **Procédé de connexion d'un composant électronique pour son test et son montage**
Verbindungsverfahren zum Testen und Montieren von elektronischen Bauelementen
Test and mounting connection method for an electronic component

(30) Priorité: 17.04.1987 FR 8705486
(43) Date de publication de la demande: 19.10.1988
(73) Titulaire: THOMSON-CSF, 75008 Paris (FR)
(72) Inventeur: Le Parquier, Guy, F-75008 Paris (FR); Val, Christian, F-75008 Paris (FR)
(74) Mandataire: Benoit, Monique

(56) Documents cités:
- EP-A- 0 213 575
- DE-A- 2 938 567

## Description

La présente invention a pour objet un procédé de connexion d'un composant électronique pour son test et son montage sur un substrat (circuit ou boîtier), ainsi qu'un dispositif pour la mise en oeuvre de ce procédé.

Ainsi qu'il est connu, afin de pouvoir monter les composants électroniques avec un bon rendement, il est nécessaire de tester et de déverminer ceux-ci avant leur montage, ceci étant particulièrement important lorsqu'il s'agit de circuits intégrés complexes. Par souci de simplicité, on ne parlera ci-après que de test, étant entendu que tout s'applique également au déverminage. Ces composants sont à tester, de préférence, dans toute la gamme de température d'utilisation, sous tension et à la fréquence d'horloge du circuit intégré, le cas échéant.

Pour monter un composant sur un substrat (circuit ou boîtier), le procédé de câblage classique consiste, on le rappelle, à connecter à l'aide de fils conducteurs chacun des plots de connexion du composant à un plot du substrat. Dans ce cas, pour opérer le test du composant avant son montage, on utilise des pointes conductrices, reliées aux appareillages de test, qu'on met en contact mécanique et électrique avec les plots des composants. Cette technique présente des insuffisances et des défauts. En effet, ces pointes ne permettent pas de faire des tests tout à fait satisfaisants, notamment par les parasites qu'elles introduisent; en particulier, elles ne permettent pas de faire des tests à haute fréquence (quelques dizaines de MHz par exemple) ; par ailleurs, elles laissent une empreinte sur les plots sur lesquels elles sont appliquées, empreintes qui fragilisent les plots et peuvent conduire à leur détérioration. Il en résulte qu'on est souvent amené à tester au moins partiellement le composant après son montage, ce qui conduit à des réparations qui deviennent nombreuses et donc longues et onéreuses lorsque le complexité du composant augmente.

Une autre solution consiste en la technique connue sous le nom de TAB ( pour Transfert Automatique sur Bande), qui est décrite plus en détail ci-après. Cette technique consiste principalement à disposer le composent sur une bande, agencée de sorte à permettre le test de ce dernier avant son montage. Toutefois, la technique TAB présente des inconvénients : le montage du composent sur le bande nécessite le présence de bossages ; ces derniers doivent être réalisés sur les plots de connexion du composant, pour permettre de souder les conducteurs portés par le bande ; cette opération est assez longue et onéreuse ; en outre une partie de la bande est en général laissée autour du composent après le test, ce qui augmente l'encombrement du composant.

Le document EP-A-213.575 décrit une technique qui présente des analogies avec le précédente et qui consiste à connecter le composent à une bande par la technique TAB, à le séparer de la bande en en conservent toutefois une partie (cadre intermédiaire supportent les pistes conductrices), à connecter l'ensemble à un substrat de test, à effectuer les tests puis à séparer le composent muni de ses pistes de l'ensemble.

La présente invention a pour objet un procédé permettant le test complet avant montage d'un composant, ne nécessitant pas un aménagement particulier du composent à tester, tel que bossages, et utilisent des éléments pour le test qui sont supprimés après celui-ci, permettent ainsi un gain en ce qui concerne l'encombrement.

Le procédé selon l'invention est plus précisément défini par le revendication 1.

L'invention à également pour objet un dispositif pour le mise en oeuvre de ce procédé tel que défini par la revendication 3.

D'autres objets, particularités et résultats de l'invention ressortiront de la description suivante, donnée à titre d'exemple non limitatif et illustrée par les dessins annexés, qui représentent :
- la figure 1, une vue de dessus du procédé connu sous le nom de TAB ;
- la figure 2, une vue en coupe selon l'axe YY de la figure précédente ;
- la figure 3, une vue en coupe du montage sur un substrat du composant une fois testé ;
- la figure 4, une vue de dessus du procédé et des moyens de connexion selon l'invention ;
- la figure 5, une vue en coupe selon l'axe XX de la figure précédente ;
- la figure 6, une vue en coupe de l'étape du montage sur un substrat du composant précédemment testé.

Sur ces différentes figures, d'une part l'échelle réelle n'a pas été respectée pour la clarté du dessin et, d'autre part, les mêmes références se rapportent aux mêmes éléments.

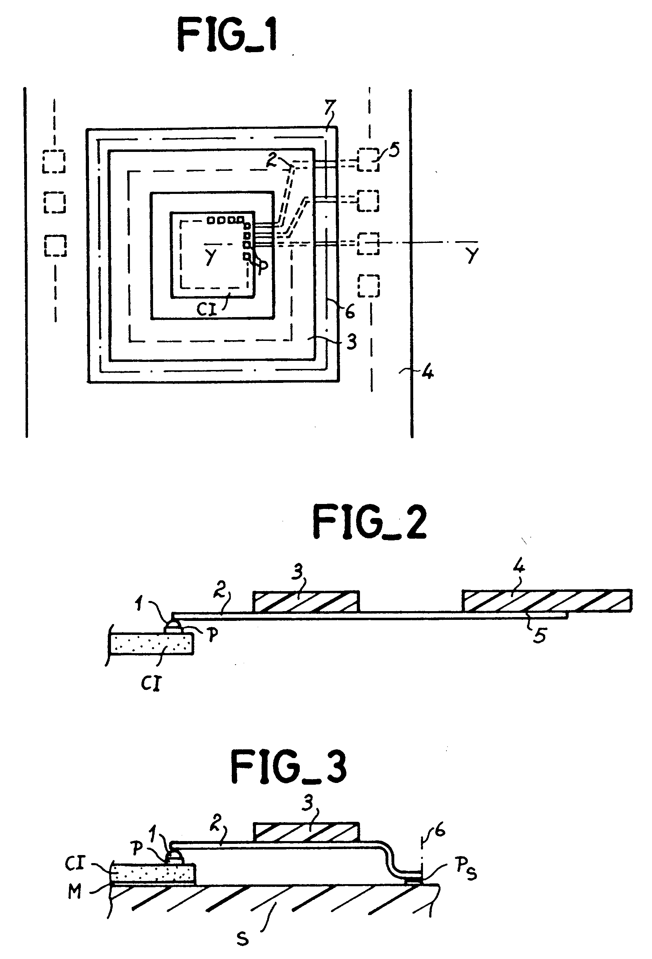

La figure 1 représente, vue de dessus, la structure utilisée par le procédé TAB.

Cette structure se compose d'une bande 4 en matériau isolant, comportant une série d'évidements centraux 7 dans chacun desquels est susceptible d'être disposé un composant à tester et à connecter ; sur la figure, on a représenté un seul évidement 7 dans lequel est disposé un composant CI, tel qu'un circuit intégré. Ce composant CI est muni à sa périphérie de plots de connexion, repérés P. La bande 4 porte sur les bords de sa face inférieure des zones métallisées 5, ou plots de test, destinées à recevoir les connexions des appareillages de test du composant CI. Le dispositif de la figure 1 comporte encore un cadre intermédiaire 3, entre la bande 4 et le composant CI.

Enfin, la bande 4 comporte, au voisinage de ses lisières, des trous de positionnement non représentés.

La figure 2 représente le dispositif de la figure précédente vu en coupe transversale partielle selon un axe YY. Sur cette coupe, on retrouve partiellement le composant CI et la bande 4, ainsi qu'un côté du cadre intermédiaire 3.

Cette coupe met en évidence la connexion électrique d'un plot P du composant CI à un plot de test 5 de la bande 4. Cette connexion électrique est réalisée à l'aide d'une bande conductrice 2, ou piste, portée par la face inférieure de la bande 4 à partir des plots 5, et maintenue par le cadre intermédiaire 3 ; la piste 2 est soudée sur le plot P par l'intermédiaire d'un bossage 1. En effet, selon ce procédé, le soudage des différentes pistes 2 sur les différents plots P est faite globalement et un bossage tel que 1 est alors nécessaire, à la fois pour compenser les irrégularités de planéité des différents plots P les uns par rapport aux autres et pour résister aux pressions nécessaires aux soudures (les plots P, très minces, présentent une résistance qui pourrait n'être pas suffisante).

Toutefois, la nécessité de ces bossages constitue un inconvénient du procédé TAB : en effet, les composants doivent subir des opérations de métallurgie supplémentaires pour la réalisation de ces bossages, ce qui est en soi un inconvénient ; par ailleurs, ces bossages s'avèrent relativement complexes à réaliser (ils nécessitent en général plus d'une demi-douzaine d'opérations différentes) ; un tel procédé n'est donc applicable qu'à des composants préalablement munis de bossages, ce qui en augmente le coût.

Lorsque le composant CI est ainsi connecté aux plots de test 5, les appareillages de test sont également connectés à ces mêmes plots 5 et les opérations de test sont réalisées. Lorsque celles-ci sont terminées, on dispose la bande 4 et le composant CI qu'elle porte sur un substrat sur lequel le composant doit être monté : substrat de circuit imprimé ou embase de boîtier, comme représenté sur la vue en coupe partielle de la figure 3.

Le composant CI est fixé au substrat S, par exemple par une couche conductrice M. Le substrat S comporte des plots de connexion Pₛ auxquels les plots P doivent être reliés ; à cet effet, on utilise les pistes 2 qui ont servi au test,soudées au composant CI ; on découpe l'ensemble des pistes 2 selon un axe de découpe 6, situé entre le cadre intermédiaire 3 et le reste de la bande 4 ; on amène les pistes 2, alors maintenues en place par le cadre intermédiaire 3, au contact des plots Pₛ du substrat S puis on les y soude.

Il apparaît ici un autre inconvénient du procédé TAB : le cadre intermédiaire 3 est maintenu définitivement autour du composant CI, augmentant ainsi son encombrement.

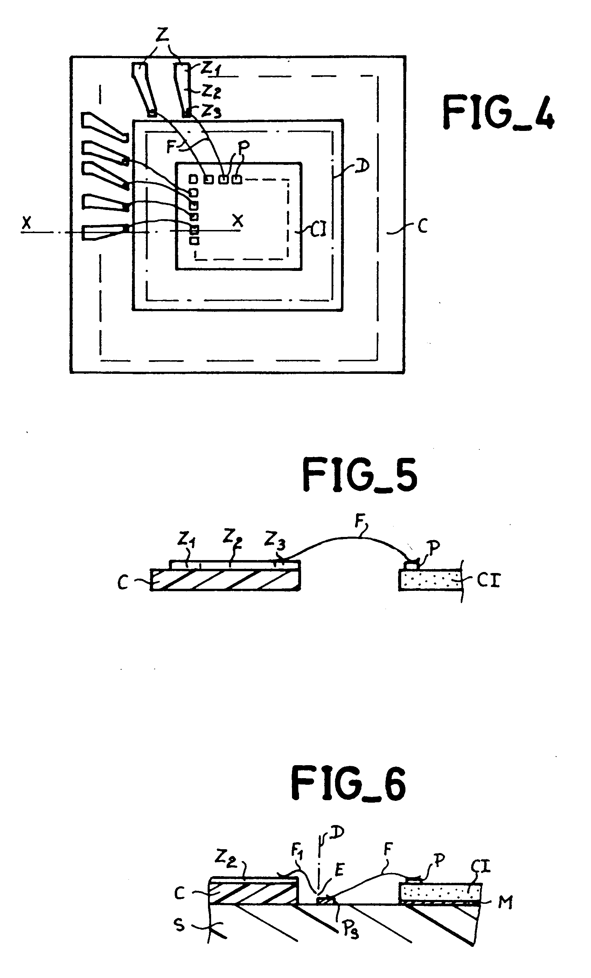

La figure 4 représente une vue de dessus de la structure utilisée dans le procédé selon l'invention.

Sur la figure 4, on a représenté le composant CI muni de ses plots de connexion P. Ce composant CI est placé à l'intérieur d'un cadre C réalisé en un matériau isolant. Le cadre C porte des métallisations Z, appelées zones de test. Plus précisément, ces métallisations sont formées chacune de préférence :
- d'un plot Z₁, ces plots Z₁ étant disposés au voisinage de la périphérie du cadre C et étant destinés à recevoir les connexions des appareillages de test du composant CI ;
- d'une piste conductrice Z₂ déposée sur le cadre C et reliant le plot Z₁ au bord intérieur du cadre C, où est disposé un second plot Z₃. Les plots P du composant CI sont reliés aux plots Z₃ par des fils conducteurs F.

Il est à noter que les plots Z₃ peuvent ou non être en face des plots P.

Les cadres tels que C peuvent se présenter en bandes continues de cadres alignés, en bandes limitées à quelques unités ou encore sous forme unitaire, le cadre C étant enchâssé dans un support du type de celui des diapositives.

Le cadre C comporte en outre, à sa périphérie, des moyens de positionnement par rapport à un composant, tels que des trous (non représentés).

La figure 5 représente le dispositif de la figure précédente, vu en coupe transversale partielle selon un axe XX.

Sur cette coupe, on retrouve partiellement le composant CI et un côté du cadre C. Cette coupe met en évidence la connexion électrique d'un plot P du composant CI au plot Z₃ par le fil F, le plot Z₃ se prolongeant par la piste Z₂ puis le plot Z₁.

Lorsque le composant CI est ainsi connecté au plot Z₁, les appareillages de test sont également connectés au plot Z₁ et les opérations de test sont réalisées.

Lorsque celles-ci sont terminées, on dispose le composant CI et son cadre C sur un substrat sur lequel le composant doit être monté, comme représenté sur la vue en coupe partielle de la figure 6.

Le composant CI est par exemple fixé sur le substrat S par une couche conductrice M, soudure ou colle. Le substrat S comporte des plots de connexions Pₛ auxquels les plots P doivent être reliés. A cet effet, on courbe le fil F de façon à ce qu'il vienne au contact du plot Pₛ, on le soude sur ce plot et on coupe le reste du fil F (partie repérée F₁) selon un axe de découpe D, situé après le plot Pₛ, de façon à permettre de dégager le cadre C pour pouvoir l'ôter.On a illustré la découpe par un espace E sur la figure 6.

Il apparaît ainsi que l'invention permet de réaliser un test complet du composant avant son montage et, ce, sans traitement particulier du composant (tel que bossages), puis de monter le composant sur un substrat sans être pénalisé au niveau de l'encombrement, puisque le cadre utilisé pour le test est ensuite supprimé.

## Revendications

1. Procédé de connexion pour son test puis son montage sur un substrat d'un composant électronique muni de plots de connexion, comportant les étapes suivantes:
- disposer autour du composant électronique (CI) un cadre (C) portant des zones conductrices (Z), lesdites zones conductrices permettant le test dudit composant (CI) par connexion à des appareillages de test;
- connecter électriquement les plots de connexion (P) du composant auxdites zones conductrices (Z), cette opération étant réalisée par câblage par des fils conducteurs (F) reliant lesdits plots (P) du composant auxdites zones conductrices (Z);
- après le test, disposer le composant électronique (CI) et le cadre (C) sur un substrat (S) muni de plots de connexion (P_{S});
- fixer le composant électronique (CI) sur ledit substrat (S);
- connecter chacun des fils (F) en un point de sa longueur à un des plots de connexion (P_{S}) du substrat;
- couper chacun des fils (F) en un point de sa longueur situé entre le plot de connexion du substrat auquel ce fil est connecté et celle des zones conductrices (Z) qui est reliée à ce fil;
- ôter le cadre (C) .

2. Procédé selon la revendication 1, caractérisé en ce que, lors de l'étape de connexion de chacun des fils (F) à un des plots de connexion (P_{S}) du substrat, chacun des fils est amené au contact d'un plot (P_{S}) du substrat par déformation puis y est soudé.

## Claims

1. A connection method for an electronic component in view of being tested prior to being mounted on a substrate, the component comprising connection studs and the method comprising the following steps:
- disposing around the electronic component (CI) a frame (C) with conducting zones (Z), said conducting zones allowing the component (CI) to be tested by a connection to test devices,
- electrically connecting the connection studs (P) of the component to the conducting zones (Z), this operation being achieved by conductor wires (F) connected to said studs (P) of the component and to said conducting zones (Z),
- disposing the electronic component (CI) and the frame (C) after the test on a substrate (S) supplied with connection studs (P_{S}),
- fixing the electronic component (CI) to said substrate (S),
- connecting each wire (F) at an intermediate point of its length to one of the connection studs (P_{S}) of the substrate,
- cutting each one of the wires (F) at an intermediate point of its length between the connection stud of the substrate to which the wire is connected and the one of the conducting zones (Z) which is connected to this wire,
- withdrawing the frame (C).

2. A method according to claim 1, characterized in that during the step of connecting each one of the wires to one of the connection studs (P_{S}) of the substrate, each wire is brought by bending in contact with a stud (P_{S}) of the substrate and is then welded thereto.

## Patentansprüche

1. Verfahren zum Anschluß eines mit Anschlußbereichen versehenen elektronischen Bauteils zuerst zu Testzwecken und anschließend zu Montagezwecken, das folgende Verfahrensschritte aufweist:
- um das elektronische Bauteil (CI) wird ein Rahmen (C) angeordnet, der leitende Zonen (Z) enthält, welche den Test des Bauteils (CI) durch Anschluß an Testgeräte erlauben,
- die Anschlußbereiche (P) des Bauteils werden an die leitenden Zonen (Z) elektrisch angeschlossen, und zwar durch Verdrahtung mittels leitender Drähte (F), die die Anschlußbereiche (P) des Bauteils mit den leitenden Zonen (Z) verbinden,
- nach dem Test werden das elektronische Bauteil (CI) und der Rahmen (C) auf ein Substrat (S) gelegt, das Anschlußbereiche (P_{S}) enthält,
- das elektronische Bauteil (CI) wird auf dem Substrat (S) befestigt,
- jeder der Drähte (F) wird an einem Zwischenpunkt seiner Länge mit einem der Anschlußbereiche (P_{S}) des Substrats verbunden,
- jeder der Drähte (F) wird an einem Punkt seiner Länge zerschnitten, der zwischen dem Anschlußpunkt des Substrats, mit dem der Draht verbunden ist, und derjenigen der leitenden Zonen (Z) liegt, mit der dieser Draht verbunden ist,
- der Rahmen (C) wird entfernt.

2. Verfahren nach Anspruch 1, dadurch gekennzeichnet, daß während des Vefahrensschritts des Anschlusses jedes der Drähte an einen der Anschlußbereiche (P_{S}) des Substrats jeder der Drähte mit einem Anschlußbereich (P_{S}) des Substrats durch Verformung in Kontakt gebracht wird, worauf er dort angeschweißt wird.
